# EUROPEAN PATENT APPLICATION

(11) **EP 4 294 142 A1**
(43) Date of publication of application: **20.12.2023**
(21) Application number: 23179235.9
(22) Date of filing: 14.06.2023
(51) Int. Cl.: H05K 9/00, H01R 13/6581

(54) **SHIELDING ARRANGEMENT, SHIELDED CONNECTION AND KIT FOR A SHIELDING ARRANGEMENT**

(30) Priority: 14.06.2022 DE 102022114882
(71) Applicant: TE Connectivity Germany GmbH, 64625 Bensheim (DE)
(72) Inventor: FERTIG, Jochen, 64625 Bensheim (DE); BULDUK, Uemit, 64625 Bensheim (DE)
(74) Representative: Grünecker Patent- und Rechtsanwälte PartG mbB

(57) **Abstract**

The invention relates to a shielding arrangement (1) for electrical or electromagnetic shielding of a shielding volume (5) open at two ends (3), a shielded connection (31) between a housing element (33) and a shielding arrangement (1), and a kit (43) for a shielding arrangement (1). Known solutions are improved in that the shielding arrangement (1) comprises a first shielding body (7) and a second shielding body (9) connected to the first shielding body (7), and that the first (7) and the second shielding body (9) are each made of different, electrically conductive materials (11). In the shielded connection (31), the housing element (33) has a receiving opening (37) in which the shielding arrangement (1) is received and in which the shielding arrangement (1) is mechanically and electrically connected to the housing element (33) by contact springs (25) or by a material bond. The kit (43) comprises a first shielding body (7) and a plurality of second shielding bodies (9, 9a, 9b, 9c), which have different lengths (45, 47, 49) in the direction of passage (17) and are designed to be connectable to the first shielding body (7).

## Description

The invention relates to a shielding arrangement for electrical or electromagnetic shielding of a shielding volume and to a kit for a shielding arrangement.

Shielding arrangements are known in the prior art. These are used to protect electrical lines or connections, for example measuring lines or lines for data transmission, from external influences such as electromagnetic stray fields.

Preferably, materials with high electrical conductivity are used for shielding. Thus, shielding arrangements for larger shielding volumes are cost-intensive and/or heavy.

Thus, it is the object of the present invention to provide a more cost-effective and/or more lightweight shielding arrangement.

This problem is solved by the invention for the initially mentioned shielding arrangement in that the shielding arrangement comprises a first shielding body and a second shielding body connected to the first shielding body, and wherein the first and the second shielding bodies each consist of different, electrically conductive materials.

Thus, by suitable selection of the materials used, the weight and manufacturing costs of the shielding arrangement can be reduced without impairing the shielding properties of the shielding arrangement.

The shielding arrangement thus has the advantage that a more cost-intensive material with good resilient properties can be used in contact areas and a more cost-effective material can be used in areas where only good electrical conductivity is required. Thus, a function of the corresponding areas of the shielding arrangement can determine the material used in these areas.

The shielding arrangement according to the invention can be further improved by the features described below. These features may be combined or omitted as desired.

The shielding volume can be open at two ends. The shielding arrangement can preferably surround or enclose the shielding volume. The shielding arrangement can also be open at two ends.

This has the advantage that elements to be shielded can be inserted into or pushed through the shielding volume.

The different, electrically conductive materials of the first and second shielding bodies may differ in at least one property from the list comprising density, tensile strength, modulus of elasticity, compressive strength, electrical conductivity, and specific thermal conductivity.

The first shielding body and/or the second shielding body can be self-contained bodies, in particular in a circumferential direction.

A self-contained body can have a connecting section at which two (preferably free) ends of a planar element can be connected to each other. In the connecting section, a shielding body can be closed in that a preferably planar element, such as a metal sheet, is bent along the circumferential direction, wherein one end of the planar element facing in the circumferential direction and one end facing against the circumferential direction can be bent toward each other. The free ends may oppose each other in the circumferential direction. The opposite ends can have complementary, interlocking joint structures which mechanically connect the opposite ends and fix them in their relative position to each other, similar to a puzzle.

Additionally or alternatively, the opposite ends may be welded together to thus form the self-contained body. The ends can be straight or have the above mentioned joint structures.

Besides the material-locking connection by welding, the ends of the planar element can also be connected to each other by force-locking or friction-locking. For this, known methods such as riveting or caulking can be used.

The connecting section can also run at an angle deviating from 90° to the circumferential direction.

The self-contained bodies may be monolithically self-contained, may be ring-shaped bodies, and in particular may be monolithic ring-shaped bodies.

Thus, the first shielding body and/or the second shielding body may be formed as a self-contained band and continuously enclose the shielding volume in a band-like manner.

Such self-contained bodies provide a circumferential gapless protection of the shielding volume and elements arranged therein against electromagnetic interference. The shielding volume is thus shielded without gaps.

It is particularly preferred if the first shielding body and the second shielding body are arranged sequentially along a direction of passage facing from the first open end of the shielding volume to the second open end of the shielding volume.

This has the advantage that elements which are to be electromagnetically shielded can be passed through the shielding arrangement along this direction. The shielding bodies arranged sequentially in the direction of passage or the sequential rings thus form a shielding volume of a length which is composed of the lengths of the individual shielding arrangements. The circumferential direction is oriented or directed around the direction of passage.

In particular, the second shielding body can have a larger expansion in the direction of passage than the first shielding body. Thus, the second shielding body can significantly determine the size of the shielding volume.

Preferably, the second shielding body is thus made of an electrically conductive material which shields the shielding volume, however it may have a lower electrical conductivity than the material of the first shielding body. The material of the second shielding body is thus preferably more cost-effective and further preferably also more lightweight than the material of the first shielding body. Thus, both the weight and the manufacturing costs of the shielding arrangement can be reduced.

For example, the second shielding body can be twice as long or twice as large in the direction of passage as the first shielding body.

Further preferably, the material of the second shielding body may have greater bending or torsional stiffness or hardness than the material of the first shielding body. For example, and not limiting, the first shielding body may be made of copper or a copper alloy and the second shielding body may be made of aluminum or an aluminum alloy. Other electrically conductive metals and alloys may also be used in any combination.

In a further configuration, the first and second shielding bodies may have interlocking or overlapping contours.

Interlocking or overlapping has the advantage of uninterrupted shielding. In this case, the first shielding body can be inserted into the second shielding body, or the second shielding body can be inserted into the first shielding body. The first and the second shielding bodies may have two continuous circumferential edges at which the first and the second shielding bodies overlap or interlock, respectively. Preferably, the first shielding body can be connected at its edge to an edge of the second shielding body.

In a further configuration, the first and second shielding bodies may be interconnected in a form-locking and/or material-locking and/or force-locking manner.

Such a connection provides uninterrupted electrical conductivity between the first and second shielding bodies so that, on one hand, eddy currents generated during shielding can also flow between the first and second shielding bodies and, on the other hand, any heat input introduced into the shielding arrangement by the eddy currents can be dissipated.

Various common methods are possible for connecting the first and second shielding bodies, for example joggling or clinching, which are suitable for connecting at least two metal sheets. Furthermore, the shielding bodies can be connected by punching, wherein preferably an undercut is created to connect the two shielding bodies. Other connecting methods are riveting or welding, such as friction welding, friction stir welding or laser welding.

In a further configuration of the shielding arrangement, a third shielding body may be provided, wherein the second shielding body is arranged between the first and third shielding bodies and is at least connected thereto.

Preferably, the second shielding body may be connected to the first and third shielding bodies. The connection of the third shielding body to the second shielding body may be identical to the connection between the first and second shielding bodies. In other configurations, different connections may be provided between the first and second shielding bodies and the second and third shielding bodies.

The third shielding body can be made of the same material as the first shielding body. The third shielding body can also be configured with further elements, for example an aggregate housing, for electrical and/or mechanical connection.

The shielding arrangement according to the invention can be further improved in that the first shielding body and/or the third shielding body comprises at least one contact arrangement.

The first shielding body may have at least one contact arrangement and the third shielding body may have at least one further contact arrangement. The contact arrangement of the third shielding body can be distinguished from the contact arrangement of the first shielding body.

By means of a contact arrangement or a further contact arrangement, the shielding arrangement can be electrically and/or mechanically connected to further elements. Preferably - as explained above - the first and/or third shielding body is made of a material with high resilience and high electrical conductivity, preferably with higher resilience and/or higher electrical conductivity than the material of the second shielding body.

Preferably, in a further configuration of the shielding arrangement, the contact arrangement and or the further contact arrangement may comprise a ring of bent contact springs or further bent contact springs. These bent contact springs may, for example, be spring-shaped.

The contact arrangement and/or the further contact arrangement may comprise at least two bent contact springs and/or at least two further bent contact springs, which may further preferably extend in different directions. In other configurations, three, four, five or more bent contact springs or further bent contact springs may be provided, which may be arranged along the circumference of the first and or third shielding body, preferably equidistantly.

The plurality of contact springs/the further contact springs can ensure reliable electrical contact between the first shielding body and a further element and/or vibration damping of the shielding arrangement. All contact springs can face in different directions, preferably perpendicularly away from the circumference of the first shielding body.

The at least two bent contact springs and/or the at least two further bent contact springs may each be bent in the direction of the second shielding body and/or extend in the direction of the second shielding body.

Thus, the first, second and third shielding bodies can form a tubular shielding arrangement. This can be configured to be mechanically and electrically conductively connected at its open ends to a further shielding arrangement or a shielded housing area.

The third shielding body can also have a plurality of preferably spring-shaped contact elements, which can form a ring of bent contact springs.

The shielding arrangement can be further improved in that the second shielding body has a larger expansion in the direction of passage than the second or third shielding body.

Preferably, the first and third shielding bodies can consist of copper and the second shielding body of aluminum. Due to the size relations between the first, the second and the third shielding body, the second shielding body requires proportionally the most material. Therefore, it is preferred if the second shielding body is made of a cheaper and/or more lightweight material than the first and second shielding bodies. Since the second shielding body is not used for electrical and/or mechanical contacting of another shielding arrangement or aggregate, the requirements on the resilience of the second shielding body are lower than those on the resilience of the first and/or third shielding body.

This has the advantage that the entire shielding arrangement can have a lower weight and can also be manufactured more cost-effectively.

The second shielding body may have stiffening structures, such as ribs.

Any of the configurations of the shielding arrangement described above may be used in a shielded connector. Such a shielded connector further comprises a connector housing, a shielding volume at least partially enclosed by the connector housing and to be electrically shielded, and a shielding arrangement, wherein the shielding arrangement encloses the shielding volume to be electrically shielded.

In a further configuration, the shielded connector may have a further shielding arrangement on a cable side facing away from a mating face of the connector. The further shielding arrangement can preferably be electrically and/or mechanically connected to the shielding arrangement according to the invention. Further preferred, this additional shielding arrangement can be connected to the shielding arrangement according to the invention in a materially locked manner. The further shielding arrangement can, for example, be a shielding of a cable. The further shielding arrangement can also shield a volume and can differ from the shielding arrangement of the shielded connector. The shielding arrangement and the further shielding arrangement can also be configured in the same way.

Continuous shielding can also be ensured on the connector side, i.e. that side of the connector to which the mating face faces. This is described below for the shielded connection according to the invention.

Thus, a shielded connection can be provided between a housing element and a shielding arrangement described above. In such a shielded connection, the housing element can have a receiving opening in which the shielding arrangement can be received and in which the shielding arrangement can be mechanically and electrically connected to the housing element by spring elements or by a material bond.

Purely by way of example, the shielding arrangement can comprise the first and second shielding bodies, wherein the second shielding body can be inserted or fitted into the receiving opening of the housing element and can be connected to the housing element. This connection can be made by welding, for example.

In another exemplary configuration, the shielding arrangement may comprise the first, the second and the third shielding bodies, wherein the third shielding body can be inserted or fitted into the receiving opening of the housing element and can be connected to the housing element via contact springs. This connection can be made, for example, by means of a latching mechanism and, in particular, can be repeatedly released. The contact springs preferably contact the housing element in a resilient manner, so that a continuous vibration-damped connection can be made or is made between the shielding arrangement and the housing element.

Further, a kit for a shielding arrangement may be provided comprising a first shielding body and a plurality of second shielding bodies, wherein the second shielding bodies may have a different length in the direction of passage and may be configured to be connectable to the first shielding body.

In a further embodiment, the kit may further comprise a third shielding body of any of the configurations described above.

The kit has the advantage that by means of the first (in the second described embodiment also the third) shielding body an electrical and/or mechanical connection to a further element can always be established and at the same time, by selecting a suitable second shielding body, the size of the shielding volume can be adapted to the respective application. Thus, the kit can be used universally for shielding volumes of different sizes. For this purpose, only the suitable second shielding body has to be selected and connected to the first (or the first and the third) shielding body.

In the following, the invention will be described in more detail with reference to the accompanying drawings. The configuration of the shielding arrangement shown in the drawings is purely exemplary and not limiting. Features shown can thus be combined with each other and/or omitted as desired.

It is shown by:
- Fig. 1: a configuration of the shielding arrangement;
- Fig. 2: a shielded connection of the shielding arrangement of Fig. 1 with a housing element;
- Fig. 3: a further configuration of the shielding arrangement;
- Fig. 4: an exploded view of the shielding arrangement of Fig. 3;
- Fig. 5: a configuration of a kit; and
- Fig. 6: an exemplary configuration of a shielded connector.

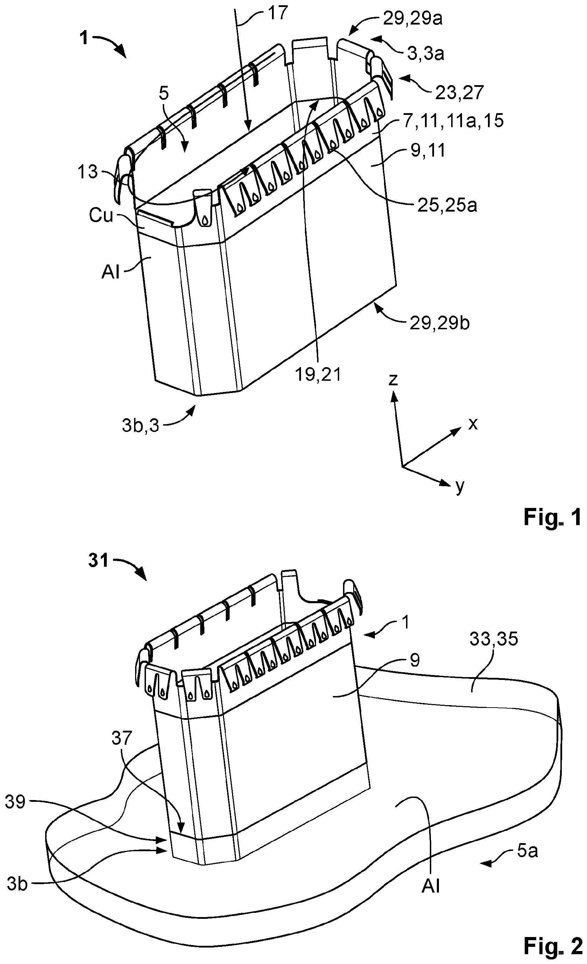

Fig. 1 shows a shielding arrangement 1 that is open at two ends 3 and surrounds a shielding volume 5. The shielding volume 5 is thus determined or defined by an expansion of the shielding arrangement 1 along a height expansion z, as well as a longitudinal expansion x and a transverse expansion y.

The shielding arrangement 1 is used for electrical or electromagnetic shielding of the shielding volume 5.

The shielding arrangement 1 comprises a first shielding body 7 and a second shielding body 9, which is connected to the first shielding body 7. Both the first 7 and the second shielding body 9 consist of an electrically conductive material 11, wherein the first shielding body 7 consists of a first electrically conductive material 11a and the second shielding body consists of a second electrically conductive material 11b. The electrically conductive materials 11a and 11b are different.

Both shielding bodies 7, 9 are self-contained bodies 15 in a circumferential direction 13. The shielding bodies 7, 9 can, for example, be monolithically self-contained.

Alternatively, the shielding bodies 7, 9 may first be formed into a self-contained body 15, for example by welding, riveting, caulking or similar methods for connecting two ends. In particular, the ends may be interconnected in the circumferential direction (not shown). These ends may be straight (for example, oriented perpendicularly to the circumferential direction 15) or have complementary interlocking joint structures.

The first shielding body 7 and the second shielding body 9 are arranged sequentially along a direction of passage 17. The direction of passage 17 is oriented parallel to height expansion z and extends from a first end 3a of the shielding volume 5 to a second end 3b of the shielding volume 5.

Along this direction of passage 17, elements that are to be electrically shielded can be passed through or placed in the shielding arrangement 1.

The second shielding body 9 can be larger than the first shielding body 7 in height expansion z or along the direction of passage 17. For example, the second shielding body 9 can be twice as large as the first shielding body 7 in the direction of passage 17.

It is particularly preferred if the first electrically conductive material 11a has particularly good resilient properties in addition to its good electrical conductivity.

Good electrical conductivity is understood to be the typical conductivity of conductors, in particular of metals, which is greater than 106 S/m (10 to the power of 6 Siemens per meter). Particularly preferably, the first shielding body 7 consists of copper Cu and the second shielding body 9 of aluminum Al. In other configurations, copper or aluminum alloys may also be used.

Both metals, copper Cu and aluminum Al, have a high electrical conductivity (for the pure metals: 58∗10⁶ S/m or 37∗10⁶ S/m, respectively). For alloys, this value falls below that for the pure metals, however both the pure metals and the alloys are suitable for electrical shielding of the shielding volume 5.

The first shielding body 7 is in electrical contact with the second shielding body 9. This electrical contact can be established by interlocking contours 19 or by an overlap 21. Further possibilities for connection are methods such as joggling or clinching, in which, for example, two metal sheets can be interconnected in a stamping process with the formation of an undercut. Alternatively, the shielding bodies 7, 9 can be riveted together. The connection between the first 7 and the second shielding body 9 can thus be form-locking.

Further possibilities for electrically connecting the first shielding body 7 to the second shielding body 9 are material-locking connections, which can be produced by welding, in particular laser welding, friction welding or friction stir welding, for example.

In the configuration shown in Fig. 1, the second shielding body 9 is inserted into the first shielding body 7. Alternatively, the first shielding body 7 can be inserted into the second shielding body 9 (such a configuration is not shown).

The configuration of the shielding arrangement 1 shown in Fig. 1 has a contact arrangement 23 formed on the first shielding body 7.

Since the first shielding body 7 is preferably made of copper Cu, which is more elastic than aluminum Al, the contact arrangement 23 is preferably reversibly deflectable.

The contact arrangement 23 may have at least one contact spring 25, preferably a plurality of contact springs 25, wherein each of the contact springs 25 extends in different directions away from the first shielding body 7.

In the embodiment shown, the contact springs 25 are bent contact springs 25a that form a ring 27, since the contact springs 25 or the bent contact springs 25a are arranged along the circumferential direction 13. For the sake of clarity, only one contact spring 25 or one bent contact spring 25a is provided with a reference sign in Fig. 1.

The shielding arrangement 1 is accessible through two oppositely disposed openings 29, a first opening 29a and a second opening 29b.

By using different materials for the first shielding body 7 and the second shielding body 9, both the weight of the shielding arrangement 1 and its manufacturing costs can be reduced. Since the first shielding body 7 is configured for the electrical contacting of further elements, it has a flexible and preferably reversibly deflectable material such as copper Cu.

With regard to its resilience, the second shielding body 9 is subject to lower requirements than the first shielding body 7. The size of the second shielding body 9 can be used to define and scale the size of the shielding volume 5.

Aluminum Al is on the one hand a suitable material for electromagnetic shielding and on the other hand has the advantage that it is more lightweight and also more cost-effective than copper Cu. Thus, the costs and the weight of the shielding arrangement 1 can be reduced without reducing the electromagnetic shielding of the shielding arrangement 1.

Fig. 2 shows a shielded connection 31 of the shielding arrangement 1 of Fig. 1 with a housing element 33.

The housing element 33 is shown only schematically in the form of a wall 35. The wall 35 of the housing element 33 also represents an electromagnetic shielding, so that the shielding volume 5 surrounded by the shielding arrangement 1 is connected to a further shielding volume 5a, which is formed by the housing element 33 and is enclosed by it.

The wall 35 of the housing element 33 has a receiving opening 37, which is configured to receive the shielding arrangement 1. The size of the receiving opening 37 is preferably somewhat larger than a base area of the shielding arrangement 1, in particular of the second shielding body 9.

The second shielding body 9 is inserted into the receiving opening 37 at the second end 3b and is electrically and mechanically connected to the wall 35 of the housing element 33 via a material-locked connection 39. Welding methods such as laser welding, friction welding or friction stir welding are suitable for this purpose. Preferably, the housing element 33 can also consist of aluminum Al, which facilitates the welding of the second shielding body 9 to the wall 35. The shielding arrangement 1 is thus captively connected to the housing element 33.

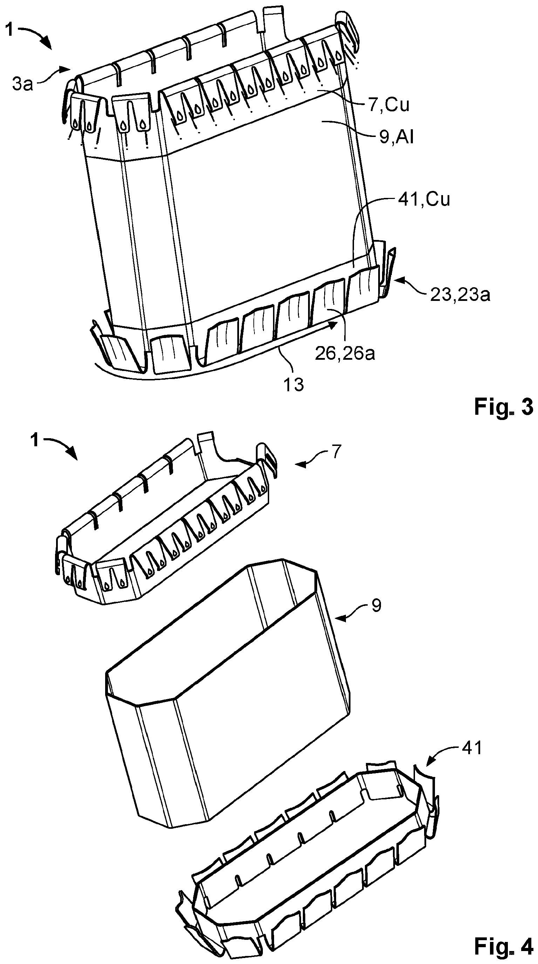

Fig. 3 shows a further configuration of the shielding arrangement 1. Like the shielding arrangement 1 described above, this consists of a first shielding body 7 and a second shielding body 9. Furthermore, the configuration shown has a third shielding body 41, which is arranged opposite the first shielding body 7 at the second end 3b of the shielding arrangement 1.

The third shielding body 41 is connected to the second shielding body 9. A connection between the third shielding body 41 and the second shielding body 9 may be identical to the connection between the first shielding body 7 and the second shielding body 9. Alternatively, for the connection between the second 9 and third shielding body 41, other methods or elements can be used than for the connection between the first 7 and second shielding body 9. The possible ways of connecting two shielding bodies 7, 9 is described above and can be transferred to the connection of the shielding bodies 9, 41.

The third shielding body 41 has a further contact arrangement 23a. The further contact arrangement 23a also comprises a plurality of further contact springs 26, which are also arranged along the circumferential direction 13, however, at the second end 3b and not at the first end 3a, and extend away from the third shielding body 41. The further contact springs 26 are further bent contact springs 26a.

In the configuration of the shielding arrangement 1 shown in Fig. 3, the bent contact springs 25a as well as the further bent contact springs 26a face away from the respective end 3a or 3b in the direction of the second shielding body 9.

The configuration of the shielding arrangement 1 shown in Fig. 3 can also form a shielded connection 31 (not shown) with a housing element 33. For this purpose, the shielding arrangement 1 can be inserted into the receiving opening 37 (see Fig. 2) such that the further bent contact springs 26a are deflected towards the second shielding body 9 when inserted into the receiving opening 37 and abut against an inner wall (not shown) of the receiving opening 37. In this case, the further bent contact springs 26a exert a contact pressure on the inner wall of the receiving opening 37, which on the one hand holds the shielding arrangement 1 securely in the receiving opening 37 and on the other hand vibrations of the housing element 33 are damped by the further bent contact springs 26a and are not transmitted directly to the shielding arrangement 1.

Preferably, the third shielding body 41 is made of copper Cu, just like the first shielding body 7.

By connecting the second shielding body 9 to the first shielding body 7 and the third shielding body 41, heat input induced by electromagnetic radiation into the shielding arrangement 1 can be effectively dissipated. Furthermore, the connection of the shielding bodies 7, 9, 41 to each other allows electrically possible paths of the eddy currents induced by the electromagnetic radiation to be not locally limited and thus the shielding arrangement 1 is not locally heated.

In Fig. 4, the shielding arrangement 1 of Fig. 3 is shown in an exploded view, wherein in this configuration the second shielding body 9 can be inserted into the first shielding body 7 as well as into the third shielding body. In other configurations (not shown), the first shielding body 7 and/or the third shielding body 41 may be insertable into the second shielding body 9.

The shielding bodies 7, 9, 41 can also have interlocking structures. These interlocking structures can, for example, be in the form of a pocket when viewed in the circumferential direction 13.

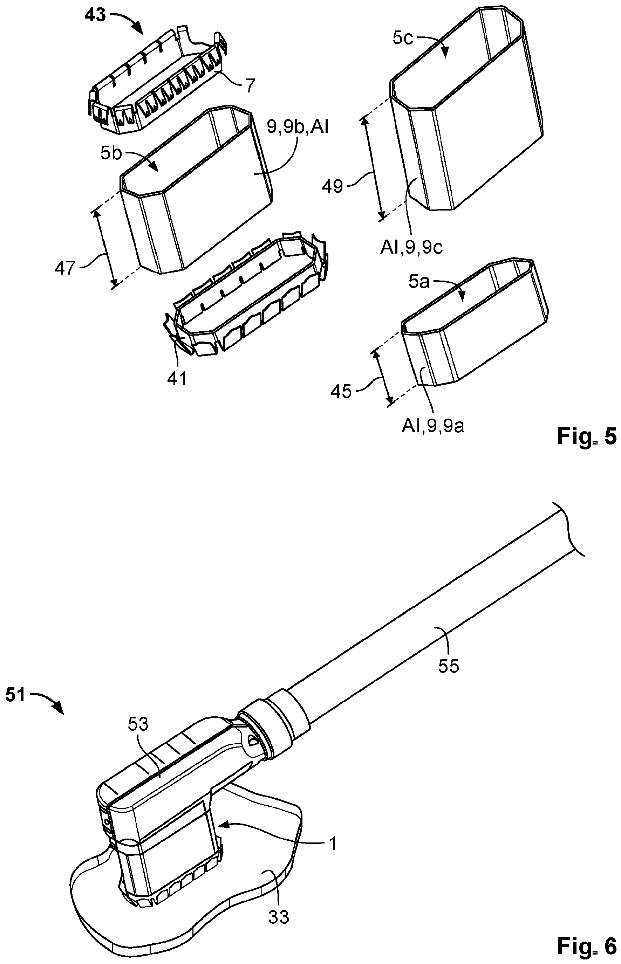

Fig. 5 shows a kit 43 for a shielding arrangement 1. This kit includes the first shielding body 7 and a plurality of second shielding bodies 9. Optionally, the kit 43 may also include the third shielding body 41, as shown in Fig. 5.

In the example shown, the kit 43 includes three second shielding bodies 9, which are referred to as shielding bodies 9a, 9b and 9c to distinguish them.

The second shielding bodies 9a, 9b and 9c are all made of aluminum Al, but can also consist of different materials.

The second shielding bodies 9a, 9b and 9c have different lengths 45, 47, 49 along the direction of passage 17 so that the kit 43 can be used to create or define shielding volumes 5 of different sizes. In this case, a first shielding volume 5a is smaller than a second shielding volume 5b and the second shielding volume 5b is smaller than a third shielding volume 5c. The kit 43 is thus versatilely applicable to cover different application areas or cases with different shielding volumes 5.

Fig. 6 shows a shielded connector 51 having a connector housing 53 which at least partially encloses a shielding volume 5, and a configuration of a shielding arrangement 1 described above. The shielded connector 51 is inserted into a housing element 33 and connected to a shielded cable 55.

### Reference Signs

- 1: shielding arrangement
- 3: end
- 3a: first end
- 3b: second end
- 5: shielding volume
- 5a: further shielding volume
- 7: first shielding body
- 9: second shielding body
- 9a, 9b, 9c: shielding bodies
- 11: electrically conductive material
- 11a: first electrically conductive material
- 11b: second electrically conductive material
- 13: circumferential direction
- 15: self-contained body
- 17: direction of passage
- 19: interlocking contours
- 21: overlap
- 23: contact arrangement
- 23a: further contact arrangement
- 25: contact spring
- 25a: bent contact spring
- 26: further contact spring
- 26a: further bent contact spring
- 27: ring
- 29: opening
- 29a: first opening
- 29b: second opening
- 31: shielded connection
- 33: housing element
- 35: wall
- 37: receiving opening
- 39: material-locked connection
- 41: third shielding body
- 43: kit
- 45: length of the second shielding body 9a
- 47: length of the second shielding body 9b
- 49: length of the second shielding body 9c
- 51: shielded connector
- 53: connector housing
- 55: shielded cable

- x: longitudinal expansion
- y: transverse expansion
- z: height expansion
- Cu: copper
- Al: aluminum

## Claims

1. Shielding arrangement (1) for electrical or electromagnetic shielding of a shielding volume (5) open at two ends (3), wherein the shielding arrangement (1) comprises a first shielding body (7) and a second shielding body (9) connected to the first shielding body (7), and wherein the first (7) and the second shielding body (9) each consist of different, electrically conductive materials (11).

2. Shielding arrangement (1) according to claim 1, wherein the first shielding body (7) and/or the second shielding body (9) are self-contained bodies (15) in a circumferential direction (13).

3. Shielding arrangement (1) according to claim 2, wherein the first shielding body (7) and/or the second shielding body (9) form self-contained bodies (15) by connecting two free ends of the respective shielding body (7, 9).

4. Shielding arrangement (1) according to claim 3, wherein the first shielding body (7) and/or the second shielding body (9) form the self-contained body or bodies (15) by interlocking joint structures and/or welding and/or riveting and/or caulking.

5. Shielding arrangement (1) according to one of claims 1 to 4, wherein the first shielding body (7) and the second shielding body (9) are arranged sequentially along a direction of passage (17) facing from the first open end (3a) of the shielding volume (5) to the second open end (3b) of the shielding volume (5).

6. Shielding arrangement (1) according to claim 5, wherein the second shielding body (9) has a larger expansion in the direction of passage (17) than the first shielding body (7).

7. Shielding arrangement (1) according to one of claims 1 to 6, wherein the first (7) and the second shielding body (9) have interlocking or overlapping contours.

8. Shielding arrangement (1) according to one of claims 1 to 7, wherein the first (7) and the second shielding body (9) are connected to one another in a form-locking and/or material-locking and/or force-locking manner.

9. Shielding arrangement (1) according to one of claims 1 to 8, comprising a third shielding body (41), wherein the second shielding body (9) is arranged between and connected to the first (7) and third shielding bodies (41).

10. Shielding arrangement (1) according to one of claims 1 to 9, wherein the first shielding body (7) and/or the third shielding body (41) has at least one contact arrangement (23).

11. Shielding arrangement (1) according to claim 10, wherein the contact arrangement (23) and/or a further contact arrangement (23a) of the third shielding body (41) has a ring (27) of bent contact springs (25a) or of further bent contact springs (26a), and wherein the bent contact springs (25a) and/or the further bent contact springs (26a) are bent towards the second shielding body (9).

12. Shielding arrangement (1) according to one of claims 7 to 11, wherein the second shielding body (9) has a larger expansion in the direction of passage (17) than the first (7) and/or the third shielding body (41).

13. Shielded connector (51) comprising a connector housing (53), a shielding volume (5) at least partially enclosed by the connector housing (53) and to be electrically shielded, and a shielding arrangement (1) according to one of claims 1 to 12 which encloses the shielding volume (5) to be electrically shielded.

14. Shielded connection (31) between a housing element (33) and a shielding arrangement (1) according to one of claims 1 to 12, wherein the housing element (33) has a receiving opening (37) in which the shielding arrangement (1) is received and in which the shielding arrangement (1) is mechanically and electrically connected to the housing element (33) by contact springs (25) or by material bond.

15. Kit (43) for a shielding arrangement (1), comprising a first shielding body (7) and a plurality of second shielding bodies (9, 9a, 9b, 9c) which have a different length (45, 47, 49) in the direction of passage (17) and are configured to be connectable to the first shielding body (7).
